# EUROPÄISCHE PATENTSCHRIFT

(11) **EP 3 963 343 B1**
(45) Veröffentlichungstag und Bekanntmachung des Hinweises auf die Patenterteilung: **15.05.2024**
(21) Anmeldenummer: 20746180.7
(22) Anmeldetag: 23.07.2020
(51) Int. Cl.: G01R 19/02, G01R 19/04

(54) **SCHALTUNG UND VERFAHREN ZUR BESTIMMUNG DES EFFEKTIVWERTES DES PHASENSTROMS EINES STROMRICHTERS**
CIRCUIT AND METHOD FOR DETERMINING THE EFFECTIVE VALUE OF THE PHASE CURRENT OF A POWER CONVERTER
CIRCUIT ET PROCÉDÉ DE DÉTERMINATION DE LA VALEUR EFFECTIVE DU COURANT DE PHASE D'UN CONVERTISSEUR DE PUISSANCE

(30) Priorität: 13.08.2019 DE 102019121776
(43) Veröffentlichungstag der Anmeldung: 09.03.2022
(73) Patentinhaber: ebm-papst Mulfingen GmbH & Co. KG, 74673 Mulfingen (DE)
(72) Erfinder: SCHROTH, Sebastian, 74635 Kupferzell (DE); WIEDMANN, Georg, 74595 Langenburg (DE)
(74) Vertreter: Staeger & Sperling Partnerschaftsgesellschaft mbB
(86) Internationale Anmeldenummer: PCT/EP2020/070854
(87) Internationale Veröffentlichungsnummer: WO 2021/028188

(56) Entgegenhaltungen:
- EP-A2- 0 881 732
- DE-T2- 69 009 619
- TIETZE U ET AL: "Halbleiter-Schaltungstechnik , Messung des Scheitelwertes", 1. Januar 1983 (1983-01-01), HALBLEITER-SCHALTUNGSTECHNIK, SPRINGER VERLAG, DE, PAGE(S) 794 - 797, XP001573337, ISBN: 978-3-540-12488-7 Seite 794 - Seite 797

## Beschreibung

Die vorliegende Erfindung betrifft eine Schaltung und ein Verfahren zur Bestimmung des Effektivwertes des Phasenstroms eines Stromrichters. Die Erfindung betrifft insbesondere eine Effektivwertbestimmung beim dreiphasigen Zweipunkt-Wechselrichters.

Im Stand der Technik sind Antriebs-Wechselrichter für Elektromaschinen mit einem Zwischenkreiskondensator auf der DC-Seite und AC-seitiger Strommessung bekannt. Hierzu wird ein Wechselrichter zur Ansteuerung eines 3-Phasen-Wechselstrommotors von einem Gleichspannungs-Zwischenkreis gespeist. Bekannte Wechselrichter weisen eine sogenannte B6-Brückenschaltung mit sechs Schaltelementen, wie Halbleiterschaltelementen in drei Schalterpaaren und sechs Freilaufdioden auf. Die Halbleiterschaltelemente können beispielsweise MOSFETs, IGBTs oder dergleichen sein. Eine Strommessvorrichtung kann zwischen der Brückenschaltung und dem Motor angeordnet sein und weist zum Beispiel Stromsensoren zur Erfassung des Stroms in den drei Phasen u, v, w auf.

Es gibt bekannte Lösungen zur "echten" Effektivwerterfassung der Phasenströme eines solchen Inverters entweder per Stromsensor in den Phasen des Inverters oder aus dem Messsignal der sogenannten Leg-Shunts in der jeweiligen Halbbrücke eines Inverters. Alternativ können IC-Bausteine zur Effektivwertmessung verwendet werden bzw. gibt es diverse IC-Bausteine am Markt.

Im Sinne dieser Erfindung ist ein Wechselrichter ein solcher Umrichter, der einen Gleichstrom in einen Wechselstrom mit Hilfe von Schaltelementen um richtet. Dabei ist der Hauptstrom ein durch das jeweilige Schaltelement zu schaltender Strom. Ein Shunt ist im Sinne der vorliegenden Erfindung ein nie-derohmiger Messwiderstand zur Messung bzw. Bestimmung eines elektri- schen Stroms, wobei der durch einen Stromfluss bewirkte Spannungsabfall abgreifbar bzw. abtastbar ist.

Ein Verfahren zur Bestimmung der Ausgangsspannung eines über einen Gleichspannungszwischenkreis gespeisten und eine Induktionsmaschine versorgenden Zweipunkt-Wechselrichters ist in der Druckschrift DE 198 13 362 A1 beschrieben. Hierbei werden in einem ersten Schritt augenblickliche Ständerphasenströme, ein Mittelwert einer Zwischenkreisspannung und augenblickliche Spannungspolaritäten der Wechselrichter-Phasen erfasst. In einem zweiten Schritt erfolgt eine Bestimmung einer Wechselrichter-Ausgangsspannung unter Berücksichtigung einer Dauer der Spannungspolaritäten. In einem dritten Schritt werden zur Ermittlung der realen Wechselrichter-Ausgangsspannung Spannungsabfälle von Halbleiterventilen des Wechselrichters berücksichtigt. In einem vierten Schritt erfolgt eine Raumzeiger-Transformation von realen Wechselrichter-Ausgangsspannungen zu einem Ständerspannungsraumzeiger.

Die DE 10 2016 217 874 A1 offenbart ein Verfahren zur Strommessung an einem Wechselrichter, wobei der Wechselrichter eine Brückenschaltung mitmehreren Schalterpaaren (A, B, C) von jeweils zwei HalbleiterSchaltelementen, die jeweils zwischen den Polen eines Gleichspannungsbusses in Reihe geschaltet sind, aufweist, wobei ein Strom über wenigstens einem Shunt abgetastet wird, der zwischen einem Hauptstromanschluss wenigstens eines der Halbleiterschaltelemente und einem ausgewählten Pol von den zwei Polen des Gleichspannungsbusses angeschlossen ist. Ferner werden eine entsprechend ausgebildete Strommessvorrichtung und eine damit aus- gestattete Wechselrichtereinheit beschrieben. Hierzu wird zwischen einem Pol und einem Fußpunkt des Wechselrichters ein Shunt eingebunden, und über dem Shunt ist ein Stromsensor parallel angeschlossen. Der Shunt und der Stromsensor bilden die Strommessvorrichtung.

Dokument EP0881732A2 offenbart eine Festkörper-Überlastschutzvorrichtung für eine Wechselstromlast, die von einer Wechselstromquelle mit Strom versorgt wird, mit einer Einrichtung zum Erfassen des tatsächlichen Stroms, der der Last von der Wechselstromquelle zugeführt wird, und einer Einrichtung zum Umwandeln des tatsächlichen Stroms in eine erste Spannung, die proportional zu dem tatsächlichen Strom ist. Eine Einrichtung ist vorgesehen, um eine zweite Spannung aus der ersten Spannung zu erzeugen, wobei die zweite Spannung proportional zu einem ungefähren Wert ist, der gleich dem Effektivstrom der Last ist, und eine Einrichtung ist vorgesehen, um die zweite Spannung zu integrieren, um ein Auslösesignal zu erzeugen, das für eine vorbestimmte Volllast-Tragfähigkeit der Wechselstromquelle repräsentativ ist.

Nachteilig bei den im Stand der Technik bekannten Strommessvorrichtungen und Verfahren ist, die Umständlichkeit und der große Aufwand dieser Verfahren, wobei diese auch nicht auf einfache Weise den Effektivwert des Phasenstroms aus dem Messsignal bestimmen können.

Wünschenswert ist daher eine technische Lösung oder ein Verfahren zum Bestimmen des Effektivwertes des Phasenstroms, der den Motor speist. Der vorliegenden Erfindung liegt daher die Aufgabe zu Grunde, vorbesagte Nach- teile im Stand der Technik zu überwinden und eine einfach und kostengünstig realisierbare Lösung zum Bestimmen des Effektivwertes des Phasenstroms eines insbesondere Dreiphasen-Wechselrichters vorzuschlagen.

Diese Aufgabe wird durch die Merkmalskombination gemäß Anspruch 1 gelöst.

Erfindungsgemäß ist hierzu eine Schaltungsanordnung zur Bestimmung eines Effektivwertes an einem PWM-getakteten Dreiphasen-Wechselrichter aus gemessenen Scheitelwerten des AC-Phasenstroms aufweisend eine Brückenschaltung mit mehreren Schalterpaaren von jeweils zwei Halbleiterschaltelementen vorgesehen, die jeweils an den Polen eines Gleichspannungszwischenkreises verbunden sind sowie ein Summenshunt zur Erfassung des Scheitelwertes des aktuell größten Phasenstromes (z. B. an einem vom Wechselrichter betriebenen EC-Motor), umfassend wenigstens eine erfin- dungsgemäße Schaltungstopologie zur Scheitelwerterfassung des AC- Phasenstroms, die ausgebildet ist, daraus den Effektivwert des Stromes zu bestimmen, wobei die Schaltung hierzu einen Operationsverstärker, eine Diode und einen ersten Widerstand und einen Kondensator in Reihe mit der Diode aufweist, wobei sich der Kondensator in Abhängigkeit vom aktuellen jeweils maximalen Scheitelwert des zu bestimmenden Phasenstroms auf einen bestimmten zum Phasenstrom korrespondierenden Wert auflädt.

Ein Grundgedanke der Erfindung sieht demnach vor den Stromfluss im Summenshunt der Schaltung zu messen. Durch die PWM-Taktung und die unterschiedlichen aktiven und passiven Schaltzustände des Wechselrichters ergibt sich ein ebenfalls getaktetes Messsignal für den AC-Phasenstrom ge- messen am Summenshunt. Dieses Messsignal wird mit Hilfe einer Scheitelwerterfassung mittels einer ersten (wie zuvor angegebenen) Schaltungstopologie in ein kontinuierliches Signal überführt. In diesem Signal wird dann lediglich der Stromfluss des zum jeweiligen Zeitpunkt größten Phasenstroms des Motors abgebildet.

Erfindungsgemäß ist die Schaltungsanordnung weiter so ausgebildet, dass ferner eine zweite Schaltungstopologie vorgesehen ist, um den minimalen Scheitelwert des AC-Phasenstroms zu ermitteln, wobei diese Schaltungstopologie hierzu ebenfalls einen Operationsverstärker, eine Diode und einen ersten Widerstand und einen Kondensator in Reihe mit der Diode vorsieht, wobei jedoch die Durchlassrichtung der Diode bei der Ermittlung des minimalen Scheitelwert des AC-Phasenstroms zwischen dem Operationsverstärker und dem Kondensator (C) eine gegenüber der Schaltungstopologie (zur Be- stimmung des maximalen Scheitelwertes) entgegengesetzte Durchlassrich- tung besitzt.

Mit Hilfe einer Scheitelwerterfassung mit langsamerer Filterzeitkonstante mit der ersten Schaltungstopologie sowie einer "invertierten" Scheitelwerterfas- sung mit der zweiten Schaltungstopologie mit der Diode in entgegengesetz- ter Durchlassrichtung (ebenfalls mit langsamerer Filterzeitkonstante) werden das Maxima und das Minima des sich ergebenden Scheitelwertverlaufs am Summenshunt ermittelt.

Alle anderen Betriebszustände des Motors lassen sich dann per Worst-Case-Abschätzung auf diese beiden Betriebsfälle zurückführen.

In einer bevorzugten Ausgestaltung der Erfindung ist daher vorgesehen, dass die erste Schaltungstopologie (zur Bestimmung des maximalen Scheitelwertes) einen zum Kondensator parallel geschalteten Widerstand vorsieht, wobei der Wiederstand so dimensioniert ist, dass sich Entladezeitkonstante R2C vergleichsweise langsam ist gegenüber der Ladezeit R1C der Scheitwerterfassung.

Für die Auswertung am Summenshunt per analoger Messschaltung kann nur der jeweils maximale Phasenstrom (der drei Phasen) am Wechselrichter erfasst werden. Die beiden dann jeweils niedrigeren Phasenströme der anderen beiden Phasen können per Scheitelwerterfassung analog nicht erfasst werden. Bei digitaler Auswertung des Messsignals können grundsätzlich alle Phasenströme erfasst werden. Hier ist lediglich eine exakte Abtastung des Messsignals erforderlich. Die Abtastzeitpunkte hängen von den einzelnen Schaltzuständen des Wechselrichters und den (minimalen) Verweildauern in diesen Schaltzuständen ab.

Mit Hilfe der beschriebenen Scheitelwerterfassung lässt sich das taktende Signal in ein kontinuierliches überführen welches lediglich den zu diesem Zeitpunkt maximalen Phasenstromwert abbildet. Im Kondensator der ersten Schaltungstopologie wird der aktuelle Scheitelwert gespeichert. Der parallel geschaltete Widerstand sorgt für die Entladung des Kondensators. Über ihn kann die Zeitkonstante der Entladedauer des Kondensators dimensioniert werden. Über den in Serie geschalteten Widerstand wird der Kondensator von dem Operationsverstärker aufgeladen. Über ihn lässt sich die Zeitkonstante der Ladedauer des Kondensators dimensionieren.

In einer weiteren vorteilhaften Ausgestaltung der Erfindung ist vorgesehen, dass die Diode so dimensioniert und deren Durchlassrichtung zum Kondensator so vorgesehen ist, dass nur größere Scheitelwerte des Phasenstroms zu einer weiteren Ladung des Kondensators führen, jedoch eine Entladung des Kondensators verhindert wird, so dass der jeweilige maximale Scheitelwert durch den Kondensator gespeichert bleibt.

Ebenfalls von Vorteil ist eine Anordnung in der ersten Schaltungstopologie, bei der nach der Diode hinter dem Operationsverstärker, insbesondere zwischen der Diode und dem Widerstand zur Bestimmung bzw. Dimensionierung der Ladezeit des Kondensators eine Rückführungsleitung zum Eingang des Operationsverstärkers führt, um dessen Eingangsspannung und die Spannung am Kondensator miteinander zu vergleichen. Der Operationsverstärker wird in disem Fall dazu verwendet, um dessen Eingangsspannung und die Spannung im Kondensator miteinander zu vergleichen und diesen schnell Laden zu können. Die Rückkopplung erfolgt hinter der Diode um die Flussspannung der Diode entsprechend kompensieren zu können.

Mit Hilfe der ersten Schaltungstopologie lässt sich der Effektivwert aus dem Scheitelwert des Scheitelwertverlaufs bestimmen. Dieses "Maxima" lässt sich mit einer weiteren Scheitelwerterfassung mit einer wesentlich langsameren Zeitkonstanten R2C dann aus dem ursprünglichen Scheitelwertverlauf ermitteln. Das bedeutet man benötigt eine zweite Scheitelwerterfassung zur Ermittlung und Speicherung des "maximalen" Scheitelwertes.

Erfindungsgemäß ist in einer weiteren bevorzugten Ausgestaltung eine zweite Schaltungstopologie vorgesehen, um den minimalen Scheitelwert des AC-Phasenstroms zu ermitteln, wobei diese Schaltungstopologie hierzu einen Operationsverstärker, eine Diode und einen ersten Widerstand und einen Kondensator in Reihe mit der Diode aufweist, wobei die Durchlassrichtung der Diode bei der Ermittlung des minimalen Scheitelwert des AC-Phasenstroms zwischen dem Operationsverstärker und dem Kondensator eine gegenüber der ersten Schaltungstopologie (zur Bestimmung des maximalen Scheitelwertes) entgegengesetzte Durchlassrichtung besitzt.

In dieser bevorzugten Ausgestaltung ist weiter mit Vorteil vorgesehen, dass die zweite Schaltungstopologie (zum Bestimmen des minimalen Scheitelwertes) einen Widerstand in Reihe mit dem Widerstand aufweist und der Kondensator mit seinem einem Anschluss zwischen dem Widerstand und dem Widerstand verbunden ist, wobei der Widerstand und der Widerstand dabei so dimensioniert sind, dass der Kondensator über den einen Widerstand geladen und über den anderen Widerstand vom Operationsverstärker entladen wird.

Auf diese Weise wird im Kondensator der aktuelle Wert des "Minimums" gespeichert. Über den zwischen dem Operationsverstärker und Kondensator vorgesehenen Widerstand wird der Kondensator von dem Operationsverstärker entladen. Über ihn lässt sich die Zeitkonstante der Entladedauer des Speichers konkret dimensionieren. Die Diode stellt sicher, dass nur kleinere Werte als deraktuell gespeicherte Scheitelwert zu einer weiteren Entladung des Kondensators führen. In dieser Schaltungstopologie wird der Operationsverstärker benötigt, um dessen Eingangsspannung und die Spannung im Kondensator miteinander zu vergleichen und den Kondensator schnell entladen zu können.

Ein weiterer Aspekt der vorliegenden Erfindung betrifft die Erfassung von Normalbetriebszustand und davon abweichenden Zuständen, wie zum Beispiel der Gleichstromfall, bei dem der Motor blockiert. Hierzu wird in einer erfindungsgemäßen Ausführung eine dritte Schaltungstopologie vorgesehen, die ausgebildet ist, um die Differenz zwischen dem maximalen Scheitelwert und dem minimalen Scheitwert zu erhalten und um aus dem Differenzwert und einem hinterlegten Sollwert oder Vergleichswert zu bestimmen, ob sich ein am Wechselrichter angeschlossener Motor in einem Normalbetrieb oder einem vom Normalbetrieb abweichenden Betrieb befindet.

Im Ergebnis liegen somit in zwei Speicherkondensatoren der jeweils ersten und zweiten Schaltungstopologie das Maxima als auch das Minima des Messsignalverlaufs im Summenshunt vor. Dabei repräsentiert der Maxima-Wert den Effektivwert des Stromes bei sinusförmigen Phasenströmen. Ist der Stromverlauf nur leicht verzerrt zum sinusförmigen Normalbetrieb (z. B. dreiecksförmiger Verlauf oder Sägezahn-Verlauf) oder fällt ein Leistungstransistor aus (positive Sinushalbwelle) kann weiterhin das Maxima als Worst-Case-Abschätzung benutzt werden, da das relative Verhältnis zwischen Effektivwert und Scheitelwert schlechter ist (Verhältnis >=√3) als im sinusförmigen Normalbetrieb (Verhältnis =^2).

Den insgesamt ungünstigsten Fall beim Verhältnis zwischen Effektivwert und Scheitelwert stellt ein Gleichstrom oder ein rechteckförmiger Stromverlauf (Verhältnis =1) dar, wobei jedoch ein rechteckförmiger Phasenstromverlauf im Messsignal am Summenshunt nicht von einem Gleichstrom zu unterscheiden ist. Im Gleichstromfall entspricht also der Effektivwert dem gemessenen "Scheitelwert", da dieser ein Gleichstrom ist.

Das einzige dann noch zur Verfügung stehende Messsignal ist der Minima-Wert. Dieses soll nun den Effektivwert eines Gleichstroms oder eines rechteckförmigen Stromverlaufs liefern. Dies lässt sich auch umsetzen, da sich im Gleichstromfall Maxima und Minima entsprechen. Um also den Effektivwert des Wicklungsstroms per Worst-Case-Abschätzung bestimmen zu können, muss noch ein Schaltungsteil hinzugefügt werden, der erkennt ob der Gleichstromfall vorliegt oder nicht und somit ein "Umschalten" zwischen den beiden Messwerten realisiert.

Wird ein Gleichstrom erkannt, dient der Minima-Wert als Worst-Case-Abschätzung für den Effektivwert des größten Phasenstroms im EC-Motor. Wird kein Gleichstromfall erkannt, dient der Maxima-Wert als Worst-Case-Abschätzung für den Effektivwert des größten Phasenstroms im EC-Motor.

Die beiden Betriebsfälle können leicht unterschieden werden. Liegen Maxima-und Minima aufeinander entspricht die Form des Stromverlaufs einem Gleichstrom. Bei allen anderen Stromverläufen sind Maxima und Minima nicht identisch. Ergibt sich eine messbare Differenz zwischen beiden Signa- len dann wird der Maxima-Messwert ausgewertet und es wird von einem sinusförmigen Stromverlauf ausgegangen.

Erfindungsgemäß ist ferner neben der zuvor beschriebenen Schaltungsanordnung auch ein Verfahren zur Strommessung eines Effektivwertes des AC-Phasenstroms an einem PWM-getakteten Dreiphasen-Wechselrichter mittels wenigstens einer solchen Schaltungsanordnung vorgesehen, wobei die folgenden Schritte durchgeführt werden:
a. es wird der getaktete Stromfluss im Summenshunt als Messsignal erfasst;
b. aus dem erfassten getakteten Messsignal wird mittels der Schaltungstopologie mit Hilfe einer Scheitelwerterfassung ein kontinuierliches Signal erzeugt;
c. es erfolgt eine Scheitelwerterfassung mittels der Schaltungstopologie zur Erfassung des maximalen Scheitelwertes mit langsamerer Filterzeitkonstante und
d. d. daraus wird der Effektivwert des AC-Phasenstromes bestimmt.

In einer bevorzugten Ausgestaltung des Verfahrens ist vorgesehen, dass zusätzlich zu dem Schritt c) noch eine Scheitelwerterfassung mittels der beschriebenen Schaltungstopologie zur Erfassung des minimalen Scheitelwertes mit langsamerer Filterzeitkonstante erfolgt und aus diesen beiden Werten und insbesondere dem Differenzwert im Vergleich zu einem Referenzwert bestimmt wird, in welchem Betriebszustand sich ein am Wechselrichter an- geschlossener EC-Motor befindet.

Andere vorteilhafte Weiterbildungen der Erfindung sind in den Unteransprü- chen gekennzeichnet bzw. werden nachstehend zusammen mit der Be- schreibung der bevorzugten Ausführung der Erfindung anhand der Figuren näher dargestellt.

Es zeigt:
- Fig. 1: eine Ansicht einer Schaltungstopologie zur Bestimmung eines maximalen Scheitelwertes;
- Fig. 2: eine Ansicht einer Schaltungstopologie zur Bestimmung eines minimalen Scheitelwertes und
- Fig. 3: eine Ansicht einer Schaltungstopologie zur Bestimmung des Betriebszustandes eines an dem Wechselrichter angeschlossenen Widerstand.

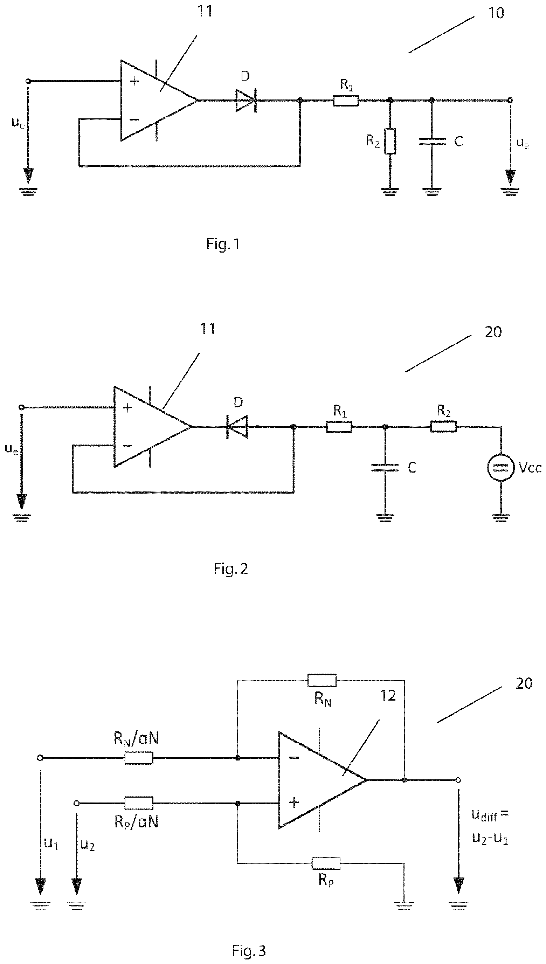

Im Folgenden wird die Erfindung anhand der beiden gezeigten Ausführungsbeispiele mit Bezug auf die Figuren 1 bis 3 näher beschrieben, wobei gleiche Bezugszeichen in den Figuren auf gleiche strukturelle und/oder funktionale Merkmale hinweisen.

In der Figur 1 findet sich eine schematische Konzeptzeichnung einer Schaltungstopologie 10 zur Bestimmung eines maximalen Scheitelwertes. Diese ist Teil einer Schaltungsanordnung zur Bestimmung eines Effektivwertes an einem PWM-getakteten Dreiphasen-Wechselrichter aufweisend eine herkömmliche Brückenschaltung mit mehreren Schalterpaaren von jeweils zwei Halbleiterschaltelementen, die jeweils an den Polen eines Gleichspannungszwi- schenkreises verbunden sind sowie ein Summenshunt zur Erfassung des Scheitelwertes des aktuell größten AC-Phasenstromes, vorzugsweise nahe- zu sinusförmigen AC-Phasenstromes.

Die Schaltungstopologie 10 besitzt zur Scheitelwerterfassung des AC-Phasenstroms einen Operationsverstärker 11, an dessen positivem Eingang E1 die Eingangsspannung Ue des Wechselrichters anliegt. Am Ausgang des Operationsverstärker 11 ist eine Diode D angeschlossen. Nach der Diode D befindet sind ein erster Widerstand R1 und ein Kondensator C, der als Speicherkondensator zum Speichern des den Scheitelwert repräsentierenden Ladungszustandes dient. Mit Ua wird die Ausgangsspannung bzw. Spannung am Kondensator definiert.

Der Kondensator lädt sich demnach in Abhängigkeit vom aktuellen jeweils maximalen Scheitelwert des zu bestimmenden Phasenstroms auf einen bestimmten korrespondierenden Wert auf und lässt sich durch das Messen von Ua gegenüber einem Referenzpotential bestimmen.

Wie bereits in der Beschreibung der Erfindung allgemein beschrieben, sorgt der Widerstand R2 für die Entladung des Kondensators C. Über ihn kann die Zeitkonstante der Entladedauer des Speichers dimensioniert werden. Über den Widerstand R1 wird der Kondensator von dem dargestellten Operationsverstärker 11 aufgeladen. Die Rückkopplung des Operationsverstärkers 11 zum negativen Eingang E2 erfolgt hinter der Diode D um deren Flussspannung entsprechend kompensieren zu können. Gleiches gilt für die Schaltungsanordnung 20 in der Figur 2.

Diese Schaltungsanordnung 20 besitzt ebenfalls einen Operationsverstärker 11, eine Diode D und einen ersten Widerstand R1 sowie einen Kondensator C in Reihe mit der Diode D. Wie gut zu erkennen ist, ist die Durchlassrichtung der Diode D in dieser Schaltungstopologie 20 in einer gegenüber der Schaltungstopologie 10 entgegengesetzten Durchlassrichtung angeordnet.

Die Schaltungstopologie 20 besitzt einen Widerstand R2 in Reihe mit dem Widerstand R1 sowie den Kondensator C mit seinem Anschluss A1 zwischen dem Widerstand R1 und dem weiteren Widerstand R2. Im Kondensator C wird der aktuelle Wert des Minimas gespeichert. Der Widerstand R1 und der Widerstand R2 sind so dimensioniert, dass der Kondensator C über den Widerstand R2 geladen und über den Widerstand R1 vom Operationsverstärker 11 entladen wird, wenn die Eingangsspannung geringer ist, als die Spannung am Kondensator, um dann den Speicher schnell entladen zu können.

In der Figur 3 wird eine Schaltungstopologie 30, umfassend den Subtrahierer 12 und die beiden Widerstände R_{N} und Rₚ, dargestellt, die eine Möglichkeit bietet den Unterschied zwischen den beiden Signalen (maximaler und minimaler Scheitelwert) zu bestimmen. Dazu wird zuerst mittels eines Subtrahierers 12 die Differenz zwischen beiden Signalen bestimmt, die jeweils mit U1, U2 bezeichnet sind und von jeweils der ersten Schaltungstopologie 10 und der zweiten Schaltungstopologie 20 stammen. Am Ausgang des Subtrahierers 12 liegt die Differenzspannung U_{diff} an. Anschließend wird diese Differenzspannung U_{diff} mittels eines Komparators mit einem Vergleichswert verglichen und bestimmt ob von einem "Normalbetrieb" ausgegangen werden kann.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht. Grundsätzlich kann das Prinzip des hier beschriebenen analogen Messverfahrens auch digital angewendet werden. Dazu wird der z. B. per Summenshunt erfasste Strom abgetastet. Durch eine zu der jeweiligen Schalterstellung im Umrichter passenden Abtastung lassen sich hier sogar die Verläufe aller drei Phasenströme nachbilden. Der Normalbetrieb wird dem Controller durch den sich im sinusförmigen Normalbetrieb typischerweise ausbildenden sechspulsigen Verlauf des Messsignals angezeigt. Dies lässt sich auch im Controller z.B. durch die Speicherung von Maxima und Minima und deren gegenseitigem Vergleich leicht ermitteln. Durch die Unterscheidung von lediglich noch zwei Betriebsfällen (Normalbetrieb, Nicht-Normalbetrieb) kann dann auch hier der Effektivstrom per Worst- Case-Abschätzung aus der Summen-Shunt-Strommessung ermittelt werden. Es sind keine zusätzlichen Phasen-Spannungs-Messungen erforderlich.

## Patentansprüche

1. Schaltungsanordnung zur Bestimmung eines Effektivwertes an einem PWM-getakteten Dreiphasen-Wechselrichter aus gemessenen Scheitelwerten des AC-Phasenstroms aufweisend eine Brückenschaltung mit mehreren Schalterpaaren von jeweils zwei Halbleiterschaltelementen, die jeweils an Polen eines Gleichspannungszwischenkreises verbunden sind sowie ein Summenshunt zur Erfassung des Scheitelwertes des aktuell größten Phasenstromes, umfassend wenigstens eine Schaltungstopologie (10) zur Scheitelwerterfassung des AC-Phasenstroms, die ausgebildet ist, daraus den Effektivwert des Stromes zu bestimmen, wobei die Schaltung (10) hierzu einen Operationsverstärker (11), eine Diode (D) und einen ersten Widerstand (R1) und einen Kondensator (C) in Reihe mit der Diode (D) aufweist, wobei sich der Kondensator in Abhängigkeit vom aktuellen jeweils maximalen Scheitelwert des zu bestimmenden Phasenstroms auf einen bestimmten korrespondierenden Wert auflädt.

2. Schaltungsanordnung nach Anspruch 1, **dadurch gekennzeichnet, dass** die Schaltungstopologie (10) einen zum Kondensator (C) parallel geschalteten Widerstand (R2) vorsieht, wobei der Wiederstand (R2) so dimensioniert ist, dass sich Entladezeitkonstante R2C des Kondensators vergleichsweise langsamen ist gegenüber der Ladezeit R1C der Scheitwerterfassung.

3. Schaltungsanordnung nach Anspruch 1 oder 2, **dadurch gekennzeichnet, dass** die Diode (D) so dimensioniert und deren Durchlassrichtung zum Kondensator so vorgesehen ist, dass nur größere Scheitelwerte des Phasenstroms zu einer weiteren Ladung des Kondensators (C) führen, jedoch eine Entladung des Kondensators (C) verhindert wird, so dass der jeweilige maximale Scheitelwert durch den Kondensator (C) gespeichert bleibt.

4. Schaltungsanordnung nach einem der vorhergehenden Ansprüche, **dadurch gekennzeichnet, dass** zwischen der Diode (D) und dem Widerstand (R1) eine Rückführungsleitung zum Eingang (E2) des Operationsverstärker (11) führt, um dessen Eingangsspannung und die Spannung am Kondensator miteinander zu vergleichen.

5. Schaltungsanordnung nach einem der vorhergehenden Ansprüche, **dadurch gekennzeichnet, dass** ferner eine Schaltungstopologie (20) vorgesehen ist, um den minimalen Scheitelwert des AC-Phasenstroms zu ermitteln, wobei die Schaltungstopologie (20) hierzu einen Operationsverstärker (11), eine Diode (D) und einen ersten Widerstand (R1) und einen Kondensator (C) in Reihe mit der Diode (D) aufweist, wobei die Durchlassrichtung der Diode (D) bei der Ermittlung des minimalen Scheitelwert des AC-Phasenstroms zwischen dem Operationsverstärker (11) und dem Kondensator (C) eine gegenüber der Schaltungstopologie (10) entgegengesetzte Durchlassrichtung besitzt.

6. Schaltungsanordnung nach Anspruch 1, **dadurch gekennzeichnet, dass** die Schaltungstopologie (20) einen Widerstand (R2) in Reihe mit dem Widerstand (R1) aufweist und der Kondensator (C) mit seinem einem Anschluss (A1) zwischen dem Widerstand (R1) und dem Widerstand (R2) verbunden ist, wobei der Widerstand (R1) und derWiderstand (R2) so dimensioniert sind, dass der Kondensator (C) über den Widerstand (R2) geladen und über den Widerstand (R1) vom Operationsverstärker (11) entladen wird.

7. Schaltungsanordnung nach einem der vorhergehenden Ansprüche 1 bis 4 und dem Anspruch 5, **dadurch gekennzeichnet, dass** ferner eine Schaltungstopologie (30) vorgesehen ist, um die Differenz zwischen dem maximalen Scheitelwert und dem minimalen Scheitwert zu erhalten und um aus dem Differenzwert und einem hinterlegten Sollwert oder Vergleichswert zu bestimmen, ob sich ein am Wechselrichter angeschlossener Motor in einem Normalbetrieb oder einem vom Normalbetrieb abweichenden Betrieb befindet.

8. Verfahren zur Strommessung eines Effektivwertes des AC-Phasenstroms an einem PWM-getakteten Dreiphasen-Wechselrichter mittels wenigstens einer Schaltungsanordnung nach einem der vorhergehenden Ansprüche 1 bis 7, wobei die folgenden Schritte durchgeführt werden:
a. es wird der getaktete Stromfluss im Summenshunt als Messsignal erfasst;
b. aus dem erfassten getakteten Messsignal wird mittels der Schaltungstopologie (10) mit Hilfe einer Scheitelwerterfassung ein kontinuierliches Signal erzeugt;
c. es erfolgt eine Scheitelwerterfassung mittels der Schaltungstopologie (10) zur Erfassung des maximalen Scheitelwertes mit langsamerer Filterzeitkonstante und
d. daraus wird der Effektivwert des AC-Phasenstromes bestimmt.

9. Verfahren nach Anspruch 8, wobei zusätzlich zu dem Schritt c) noch eine Scheitelwerterfassung mittels der Schaltungstopologie (20) zur Erfassung des minimalen Scheitelwertes mit langsamerer Filterzeitkonstante erfolgt und aus diesen beiden Werten und insbesondere dem Differenzwert im Vergleich zu einem Referenzwert bestimmt wird, in welchem Betriebszustand sich ein am Wechselrichter angeschlossener EC-Motor befindet.

10. Verfahren nach Anspruch 9, wobei als ein fehlerhafter Betriebszustand ein Zustand betrachtet wird, bei dem der maximale und der minimale Scheitelwert gleich oder nahezu gleich groß sind.

## Claims

1. A circuit arrangement for determining an RMS value at a PWM-actuated three-phase power inverter from measured peak values of the AC phase current, having a bridge circuit with a plurality of switch pairs of two semiconductor switching elements each which are respectively connected to poles of an intermediate DC circuit, and a residual shunt for detecting the peak value of the currently largest phase current, comprising at least one circuit topology (10) for detecting the peak value of the AC phase current which is designed to determine the RMS value of the current therefrom, the circuit (10) having for this purpose an operational amplifier (11), a diode (D), and a first resistor (R1) and a capacitor (C) in series with the diode (D), the capacitor being charged to a specific corresponding value as a function of the respective current maximum peak value of the phase current that is to be determined.

2. The circuit arrangement according to claim 1, **characterized in that** the circuit topology (10) provides a resistor (R2) that is connected in parallel with the capacitor (C), the resistor (R2) being dimensioned such that the electric discharge time constant R2C of the capacitor is comparatively slower than the charge time R1C of the peak value detection.

3. The circuit arrangement according to claim 1 or 2, **characterized in that** the diode (D) is dimensioned and its forward direction to the capacitor provided such that only larger peak values of the phase current result in further charging of the capacitor (C), but a discharging of the capacitor (C) is prevented, so that the respective maximum peak value remains stored by the capacitor (C).

4. The circuit arrangement according to any one of the preceding claims, **characterized in that** a feedback line leads between the diode (D) and the resistor (R1) to the input (E2) of the operational amplifier (11) for the purpose of comparing the input voltage thereof and the voltage at the capacitor with one another.

5. The circuit arrangement according to any one of the preceding claims, **characterized in that** a circuit topology (20) is also provided in order to determine the minimum peak value of the AC phase current, wherein the circuit topology (20) has for this purpose an operational amplifier (11), a diode (D), and a first resistor (R1) and a capacitor (C) in series with the diode (D), the forward direction of the diode (D) having a forward direction opposite to that of the circuit topology (10) when determining the minimum peak value of the AC phase current between the operational amplifier (11) and the capacitor (C).

6. The circuit arrangement according to claim 1, **characterized in that** the circuit topology (20) has a resistor (R2) in series with the resistor (R1), and the capacitor (C) is connected with its one terminal (A1) between the resistor (R1) and the resistor (R2), the resistor (R1) and the resistor (R2) being dimensioned such that the capacitor (C) is charged via the resistor (R2) and discharged by the operational amplifier (11) via the resistor (R1).

7. The circuit arrangement according to any one of preceding claims 1 to 4 and claim 5, **characterized in that** a circuit topology (30) is also provided in order to obtain the difference between the maximum peak value and the minimum peak value and in order to determine from the difference value and a stored setpoint value or comparison value whether a motor that is connected to the power inverter is in normal operation or in a mode different from normal operation.

8. A method for current measurement of an RMS value of the AC phase current at a PWM-actuated three-phase power inverter by means of at least one circuit arrangement according to any one of preceding claims 1 to 7, wherein the following steps are carried out:
a. the clocked current flow in the residual shunt is detected as a measurement signal;
b. a continuous signal is generated from the detected clocked measurement signal by means of the circuit topology (10) with the aid of peak value detection;
c. peak value detection is carried out using the circuit topology (10) in order to detect the maximum peak value with a slower filter time constant; and
d. the RMS value of the AC phase current is determined therefrom.

9. The method according to claim 8, wherein, in addition to step c), peak value detection is carried out by means of the circuit topology (20) in order to detect the minimum peak value with a slower filter time constant, and the operating state of an EC motor that is connected to the power inverter is determined from these two values and in particular from the difference value in comparison to a reference value.

10. The method according to claim 9, wherein a faulty operating state is considered to be a state in which the maximum and minimum peak values are equal or nearly equal.

## Revendications

1. Agencement de circuit permettant de déterminer une valeur effective au niveau d'un onduleur triphasé cadencé par MLI à partir de valeurs de crête mesurées du courant alternatif de phase, présentant un montage en pont avec plusieurs paires de commutateurs de respectivement deux éléments de commutation à semi-conducteurs qui sont respectivement reliés à des pôles d'un circuit intermédiaire de tension continue, ainsi qu'un shunt additif pour détecter la valeur de crête du courant de phase actuellement le plus élevé, comprenant au moins une topologie de circuit (10) pour la détection de valeur de crête du courant alternatif de phase, qui est réalisée pour déterminer la valeur effective du courant sur cette base, dans lequel le circuit (10) présente à cet effet un amplificateur opérationnel (11), une diode (D) et une première résistance (R1) et un condensateur (C) en série avec la diode (D), dans lequel le condensateur se recharge jusqu'à une valeur correspondante déterminée, en fonction de la valeur de crête actuelle, respectivement maximale, du courant de phase à déterminer.

2. Agencement de circuit selon la revendication 1, **caractérisé en ce que** la topologie de circuit (10) prévoit une résistance (R2) connectée en parallèle avec le condensateur (C), la résistance (R2) étant dimensionnée de telle sorte que la constante de temps de décharge R2C du condensateur est plus lente en comparaison avec le temps de charge R1C de la détection de valeur de crête.

3. Agencement de circuit selon la revendication 1 ou 2, **caractérisé en ce que** la diode (D) est dimensionnée et le sens passant de celle-ci vers le condensateur sont prévus de telle sorte que seules des valeurs de crête plus élevées du courant de phase conduisent à une charge supplémentaire du condensateur (C) mais qu'une décharge du condensateur (C) est empêchée de sorte que la valeur de crête maximale respective est toujours stockée par le condensateur (C).

4. Agencement de circuit selon l'une quelconque des revendications précédentes, **caractérisé en ce qu'**entre la diode (D) et la résistance (R1), une ligne de retour mène à l'entrée (E2) de l'amplificateur opérationnel (11) pour comparer l'une avec l'autre la tension d'entrée de celui-ci et la tension au niveau du condensateur.

5. Agencement de circuit selon l'une quelconque des revendications précédentes, **caractérisé en ce qu'**en outre une topologie de circuit (20) est prévue pour établir la valeur de crête minimale du courant alternatif de phase, dans lequel la topologie de circuit (20) présente à cet effet un amplificateur opérationnel (11), une diode (D) et une première résistance (R1) et un condensateur (C) en série avec la diode (D), dans lequel lors de l'établissement de la valeur de crête minimale du courant alternatif de phase entre l'amplificateur opérationnel (11) et le condensateur (C), le sens passant de la diode (D) présente un sens passant opposé par rapport à la topologie de circuit (10).

6. Agencement de circuit selon la revendication 1, **caractérisé en ce que** la topologie de circuit (20) présente une résistance (R2) en série avec la résistance (R1), et le condensateur (C) est relié par une borne (A1) de celui-ci entre la résistance (R1) et la résistance (R2), dans lequel la résistance (R1) et la résistance (R2) sont dimensionnées de telle sorte que le condensateur (C) est chargé par l'intermédiaire de la résistance (R2) et est déchargé par l'intermédiaire de la résistance (R1) par l'amplificateur opérationnel (11).

7. Agencement de circuit selon l'une quelconque des revendications précédentes 1 à 4 et la revendication 5, **caractérisé en ce qu'**en outre une topologie de circuit (30) est prévue pour obtenir la différence entre la valeur de crête maximale et la valeur de crête minimale, et pour déterminer à partir de la valeur de différence et d'une valeur de consigne mémorisée ou d'une valeur de comparaison si un moteur connecté à l'onduleur se trouve dans un mode normal ou dans un mode s'écartant du mode normal.

8. Procédé de mesure de courant d'une valeur effective du courant alternatif de phase au niveau d'un onduleur triphasé cadencé par MLI au moyen d'au moins un agencement de circuit selon l'une quelconque des revendications précédentes 1 à 7, dans lequel les étapes suivantes sont exécutées :
a. le flux de courant cadencé est détecté dans le shunt additif sous forme de signal de mesure ;
b. à partir du signal de mesure cadencé détecté, un signal continu est généré au moyen de la topologie de circuit (10) à l'aide d'une détection de valeur de crête ;
c. une détection de valeur de crête est effectuée au moyen de la topologie de circuit (10) pour détecter la valeur de crête maximale ayant la constante de temps de filtre plus lente, et
d. la valeur effective du courant alternatif de phase est déterminée sur cette base.

9. Procédé selon la revendication 8, dans lequel en plus de l'étape c), une détection de valeur de crête est également effectuée au moyen de la topologie de circuit (20) pour détecter la valeur de crête minimale ayant la constante de temps de filtre plus lente, et à partir de ces deux valeurs, et en particulier à partir de la valeur de différence en comparaison avec une valeur de référence, on détermine dans quel état de fonctionnement se trouve un moteur à commutation électronique connecté à l'onduleur.

10. Procédé selon la revendication 9, dans lequel on considère comme un état de fonctionnement défectueux un état dans lequel la valeur de crête maximale et la valeur de crête minimale sont identiques ou presque identiques.
